(19) **Europäisches Patentamt / European Patent Office / Office européen des brevets**

(11) **EP 4 404 249 A1**

(12) # EUROPEAN PATENT APPLICATION
published in accordance with Art. 153(4) EPC

(43) Date of publication:
**24.07.2024 Bulletin 2024/30**

(21) Application number: **22869736.3**

(22) Date of filing: **12.08.2022**

(51) International Patent Classification (IPC):
*H01L 21/68* (2006.01)     *H01J 37/18* (2006.01)
*H01J 37/20* (2006.01)

(52) Cooperative Patent Classification (CPC):
**H01J 37/18; H01J 37/20; H01L 21/68**

(86) International application number:
**PCT/JP2022/030744**

(87) International publication number:
**WO 2023/042589 (23.03.2023 Gazette 2023/12)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **17.09.2021 JP 2021152355**

(71) Applicant: **Hitachi, Ltd.**
**Tokyo 100-8280 (JP)**

(72) Inventor: **TAKAHASHI, Motohiro**
**Tokyo 100-8280 (JP)**

(74) Representative: **Mewburn Ellis LLP**
**Aurora Building**
**Counterslip**
**Bristol BS1 6BX (GB)**

(54) **STAGE DEVICE, CHARGED PARTICLE BEAM DEVICE, AND VACUUM DEVICE**

(57)     Provided is a stage device capable of appropriately positioning an object. Thus, a stage device (10) is provided with: a fixed unit (20) including a top plate (22) including a magnetic material, a bottom plate (26) opposing the top plate (22), and a plurality of coils (28) provided on an upper surface of the bottom plate (26); and a movable unit (100) comprising a support portion (101) for supporting an object (160) to be positioned, a plurality of first magnets (141) mounted to the upper surface of the support portion (101) and opposed to the top plate (22) to generate a first propulsion force (FA) against the top plate (22), and a plurality of second magnets (105) provided on a lower surface of the support portion (101) and opposed to the coil (28) to generate a second propulsion force (FB) between the coil (28) and the plurality of second magnets (105).

FIG. 1

EP 4 404 249 A1

## Description

Technical Field

The present invention relates to a stage device, a charged particle beam device, and a vacuum device.

Background Art

As background art of the present technical field, the following Abstract of PTL 1 discloses "A moving device (701) having a first portion with a carrier (714), particularly for use in the semiconductor industry, wherein in the carrier, a magnet system (710) is arranged according to a pattern of rows and columns extending parallel to the X and Y directions. The magnets in each row and column are arranged according to a Hall Bach array, i.e., the magnetic orientation of the continuous magnets in each row and each column is rotated 90 degrees counterclockwise. A second portion has an electrical coil system (712) of two types of electrical coils, one type having an angular offset of 45° and the other type having an offset of -45° with respect to the X direction. The first portion (714, 710) is movable over a range of the order of centimeters or more with respect to the stationary second portion (712). An interferometer system (731, 730) is provided for highly accurate positioning of the first portion."

The description of this document is included as part of this specification.

Citation List

Patent Literature

PTL 1: JP 2008-527964 T

Summary of Invention

Technical Problem

By the way, in the above-described technology, there is a demand for more appropriate positioning of a subject.

The present invention has been made in view of the above circumstances, and an object thereof is to provide a stage device, a charged particle beam device, and a vacuum device capable of appropriately positioning a subject.

Solution to Problem

In order to solve the above problems, a stage device according to the present invention includes: a fixing portion including a top plate including a magnetic material, a bottom plate facing the top plate, and a plurality of coils provided on an upper surface of the bottom plate; and a movable portion including a support portion that supports a subject to be positioned, a plurality of first magnets that are mounted on an upper surface of the support portion, face the top plate, and generate a first thrust force against the top plate, and a plurality of second magnets that are provided on a lower surface of the support portion, face the coil, and generate a second thrust force against the coil.

Advantageous Effects of Invention

According to the present invention, a subject can be appropriately positioned.

Brief Description of Drawings

[Fig. 1] Fig. 1 is a schematic cross-sectional view of a magnetic levitation flat stage device according to a first embodiment.
[Fig. 2] Fig. 2 is a schematic plan view of a movable portion as viewed in a Z-axis direction.
[Fig. 3] Fig. 3 is a diagram illustrating an arrangement relationship between a movable portion and an electron optical system device.
[Fig. 4] Fig. 4 is a diagram illustrating another arrangement relationship between the movable portion and the electron optical system device.
[Fig. 5] Fig. 5 is a schematic cross-sectional view of a magnetic levitation flat stage device according to a second embodiment.

[Fig. 6] Fig. 6 is a schematic cross-sectional view of a semiconductor measurement device according to a third embodiment.

[Fig. 7] Fig. 7 is a schematic cross-sectional view of a magnetic levitation flat stage device according to a first comparative example.

[Fig. 8] Fig. 8 is a schematic cross-sectional view of a magnetic levitation flat stage device according to a second comparative example.

[Fig. 9] Fig. 9 is another schematic cross-sectional view of a magnetic levitation flat stage device according to the second comparative example.

Description of Embodiments

[Outline of Embodiment]

Conventionally, a technique related to a device stage applied to an exposure device or the like and a magnetic levitation flat stage for accurately positioning and supporting a wafer is known. This is a magnetic levitation flat stage mechanism that moves the device relative to the mounting base. The conventional magnetic levitation flat stage mechanism has a magnet array in which a coil is mounted on a floating movable table side and magnets are regularly laid on a base on a fixed side. In order to keep the floating, it is necessary to always support the gravity of the movable portion, and the force is covered by the Lorentz force obtained by applying a current to the coil.

In particular, in this system, a coil that is a heating element is provided on the floating side. Therefore, when a chuck for supporting a sample such as a wafer or a device having a certain mass is mounted on the movable table, the mass of the movable table increases, and coil heat generation for gravity support increases. In order to prevent burnout of the coil due to this, measures such as supplying a refrigerant to the coil and coil peripheral components are required, and deterioration of drive characteristics due to resistance force of the refrigerant pipe becomes a problem. In addition, since a leakage magnetic field from the spread magnet array is large, it is difficult to mount the magnetic field on a charged particle beam device or the like.

On the other hand, when the technique of PTL 1 is applied, it is considered that it is possible to realize a magnetic levitation flat stage in which the movable portion side is a magnet and the fixing portion side is a coil. In this system, since the coil is on the fixed side, a refrigerant pipe is unnecessary for the movable portion, and a problem that drive characteristics are deteriorated is solved. However, also in this case, it is necessary to continuously flow a large amount of current to the coil array in order to always support the gravity of the movable portion. Here, when there is a positional relationship in which the magnet cannot cover and hide the energized coil, there is a problem that the leakage magnetic field from the coil reaches the upper side, that is, near the charged particle beam. In addition, in the device, a large thrust force is constantly applied in the vertical direction in order to support gravity. Therefore, the current noise increases due to the limitation of the dynamic range of the current amplifier that supplies the current to the coil, and minute thrust fluctuation occurs due to the noise of the coil current, leading to vibration of the movable portion.

Incidentally, for example, in processes such as manufacturing, measurement, and inspection of a semiconductor wafer, the above-described stage device is used to accurately position the semiconductor wafer. In such a stage device, it is required to improve positioning accuracy of a semiconductor wafer.

However, the conventional stage device described above has a problem of drive characteristic degradation due to the water-cooled pipe and a problem of minute vibration due to the dynamic range of the current amplifier, and it is difficult to improve positioning accuracy. In addition, there is a problem of a leakage magnetic field, and application to a charged particle beam device is difficult.

Therefore, embodiments to be described later provide a stage device, a charged particle beam device, and a vacuum device capable of improving positioning accuracy and suppressing leakage of a magnetic field.

[First embodiment]

<Configuration of First Embodiment>

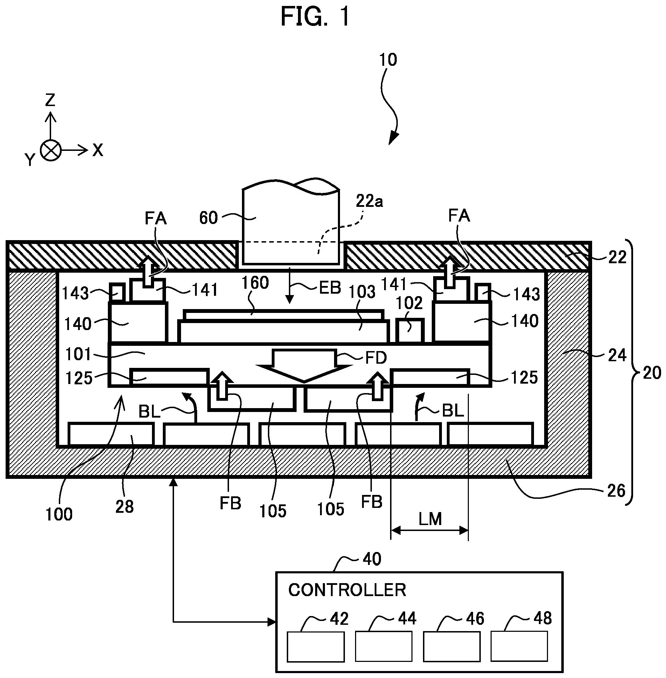

Fig. 1 is a schematic cross-sectional view of a magnetic levitation flat stage device 10 (stage device) according to a first embodiment.

In Fig. 1, the magnetic levitation flat stage device 10 includes a fixing portion 20, a movable portion 100, and a controller 40. The fixing portion 20 is formed in a substantially rectangular parallelepiped box shape, and includes a top plate 22, a side wall 24, and a bottom plate 26. The top plate 22 and the bottom plate 26 are formed in a rectangular plate shape, and are arranged to face each other in the up-down direction, that is, the Z direction. The side wall 24 is disposed along the peripheral edges of the top plate 22 and the bottom plate 26, and is fixed to the top plate 22 and the bottom plate 26.

An insertion port 22a (through hole) cut out in a cylindrical shape is formed in a substantially central portion of the top plate 22. In the illustrated example, an electron optical system device 60 having a substantially cylindrical shape is inserted through the insertion port 22a. The electron optical system device 60 emits an electron beam EB (charged particle beam).

A plurality of coils 28 are arranged on the upper surface of the bottom plate 26. The coils 28 are formed in a rectangular plate shape and are two-dimensionally arranged along the X direction and the Y direction. The coil described in PTL 1 described above can be applied to the coil 28. The top plate 22 is obtained by processing a magnetic material into a plate shape. However, the entire top plate 22 does not need to be a magnetic material, and at least a part thereof may be a magnetic material, for example, the lower surface may be a magnetic material.

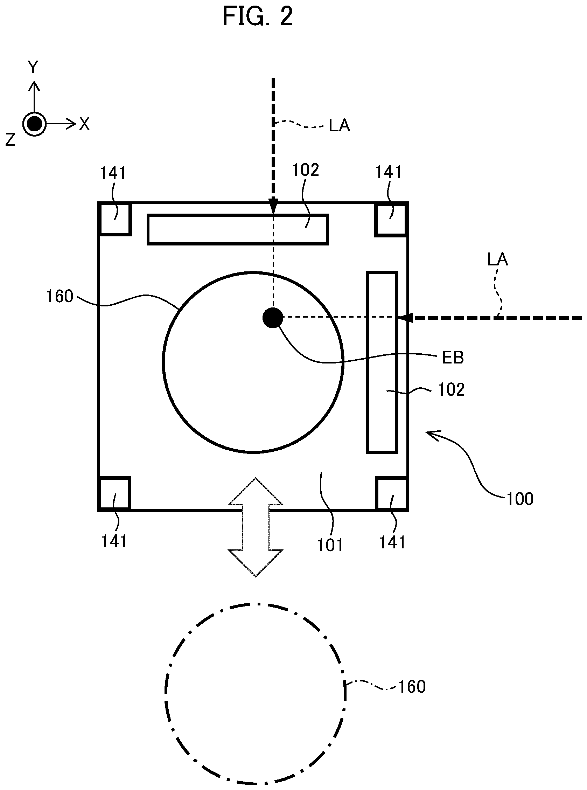

The movable portion 100 moves in the internal space of the fixing portion 20, and includes a top table 101 (support portion), a bar mirror 102, an electrostatic chuck 103, a magnet 105 (second magnet), a magnetic shield 125, a magnet support base 140, a magnet 141 (first magnet), and a displacement sensor 143 (position sensor). The top table 101 is formed in a rectangular plate shape (see Fig. 2). The bar mirror 102 and the electrostatic chuck 103 are fixed to the upper surface of the top table 101. Here, the electrostatic chuck 103 is formed in a disk shape, and adsorbs a subject 160 (see Fig. 2) such as a sample on the upper surface thereof. In the illustrated example, the subject 160 is formed in a disk shape.

In the illustrated example, the magnet support base 140 is fixed to the upper surfaces of the four corners of the top table 101. The magnet 141 and the displacement sensor 143 are disposed on the upper surface of the magnet support base 140. The magnet 141 is, for example, a permanent magnet. The magnet 141 generates a thrust force FA (first thrust force) by a magnetic attractive force with respect to the top plate 22 at least a part of which is a magnetic material. Here, the dimensions and the magnetic field strength of the magnet 141 may be determined so that the thrust force FA and a gravity FD applied to the movable portion 100 are balanced when the movable portion 100 has an appropriate predetermined height.

A plurality of rectangular plate-shaped magnets 105 are mounted so as to face the coil 28 at the central portion of the lower surface of the top table 101. The magnetic shield 125 is disposed so as to surround the periphery of these magnets 105. The magnetic shield 125 prevents a leakage magnetic field BL generated by the coil 28 from rotating above the top table 101. For example, in a case where the magnetic levitation flat stage device 10 is a part of an electron microscope, if the trajectory of the electron beam EB is distorted, focus blurring or positional deviation occurs in an observation image. In the present embodiment, by providing the magnetic shield 125, problems such as focus blurring and positional deviation can be suppressed.

The coil 28 and the magnet 105 repel each other by the Lorentz force to generate an upward thrust force FB (second thrust force) in the movable portion 100, and have a function as a lifting device that raises and lowers the movable portion 100 in the vertical direction (Z direction). Furthermore, the coil 28 and the magnet 105 also have a function of a two-dimensional linear stepping motor that moves the movable portion 100 in the horizontal direction (X direction and Y direction).

As described above, the dimensions and the like of the magnet 141 may be determined so that the thrust force FA and the gravity FD are balanced when the movable portion 100 has a predetermined height. The periphery of the magnet 141 may be shielded by a magnetic material or the like (not illustrated). As a result, a magnetic circuit in which a magnetic field is generated only in the magnet 141 and a part of the top plate can be formed, and the influence on the electron beam EB can be suppressed.

However, it is difficult to stabilize the height of the movable portion 100 only with the magnet 141 and the top plate 22. Therefore, the magnet 105 may be biased in the Z direction by the current supplied to the coil 28 to adjust the minute imbalance of gravity support. Further, the height of the movable portion 100 can be stabilized by compensating for the pitching moment at the time of acceleration/deceleration.

As a result, it is possible to extremely reduce the thrust force FB in the Z direction that needs to be generated by the magnet 105 and the coil 28, and it is not necessary to flow a large current for supporting gravity in the coil 28. In other words, the leakage magnetic field BL output from the coil 28 during energization can be made extremely small.

In addition, since the displacement sensor 143 is mounted in the vicinity of the magnet 141, the relative distance between the magnet 141 and the top plate 22 can be measured, thereby enabling posture measurement and posture control of the movable portion 100. Furthermore, since the magnetic shield 125 is arranged around the plurality of magnets 105 on the lower surface of the top table 101, it is possible to shield the minute leakage magnetic field BL generated from the plurality of coils 28 and further suppress the influence thereof. Note that a width LM of the magnetic shield 125 is preferably 0.5 times or more the width of the coil 28, and more preferably 1.0 times or more the width of the coil 28.

The controller 40 includes a position command unit 42, a position detection unit 44, a current command unit 46, and a current amplifier 48. Here, the position command unit 42 outputs a command value of the position of the movable portion 100, that is, a command value of coordinates in the X, Y, and Z directions based on the measurement plan of the subject 160. The position detection unit 44 outputs a measurement result of the actual position of the movable portion 100, that is, coordinate values in the X, Y, and Z directions. The current command unit 46 outputs a current command value that commands a current to be passed through each coil 28 based on a deviation between the command value of the position of the movable portion 100 and the measurement result of the actual position. The current command value is an analog signal. The current amplifier 48 amplifies the current command value and supplies the amplified current command value to each coil 28.

Here, problems that may occur due to the current amplifier 48 will be described. The current amplifier 48 has a limited dynamic range due to a performance limit of an element (not illustrated) of a mounted current control circuit. The larger the current amplifier 48 outputs the maximum output current, the larger the noise included in the output current becomes, and the larger the output current is, the larger the noise included in the output current becomes. When this current noise is input to the coil 28, minute fluctuation of the thrust force occurs, leading to minute vibration of the movable portion 100. For example, in a case where the coil 28 constantly generates a large thrust force in the Z direction, minute vibration in the Z direction continues to be constantly generated in the movable portion 100. Such minute vibration of the movable portion 100 degrades positioning resolution and causes degradation of positioning accuracy.

In particular, in the plurality of coils 28, when independent noises are generated in the Z-direction thrust force, vibration of the posture control around the X-axis and the Y-axis is also caused, and the positioning accuracy in the XY direction is also deteriorated. In the present embodiment, since the Z-direction thrust force to be generated by the coil 28 in order to support the mass of the movable portion 100 can be reduced, the output current of the current amplifier 48 can also be reduced. As a result, since a noise component output from the current amplifier 48 can also be suppressed, minute vibration generated in the movable portion 100 can also be suppressed, and the positioning accuracy of the movable portion 100 can be enhanced.

Fig. 2 is a schematic plan view of the movable portion 100 as viewed from the Z-axis direction. In Figs. 2 to 4, the magnet support base 140, the displacement sensor 143, and the like are not illustrated in order to prevent the drawing from being complicated.

In Fig. 2, two bar mirrors 102 are disposed on the upper surface of the top table 101. These bar mirrors 102 are provided to measure the position of the movable portion 100 with a laser interferometer (not illustrated) . The laser interferometer is included in the position detection unit 44 (see Fig. 1) of the controller 40. The laser interferometer irradiates these bar mirrors 102 with a pair of laser optical axes LA. The laser interferometer is disposed such that an intersection of the laser optical axes LA coincides with an irradiation point of the electron beam EB.

As described above, the magnets 141 are preferably arranged at the four corners of the top table 101 as illustrated so as not to block the laser optical axis LA. Further, when the subject 160 is replaced, it is convenient if the subject 160 can be taken in and out from the negative side in the Y direction. Therefore, also for this reason, the magnets 141 are preferably arranged at the four corners of the top table 101.

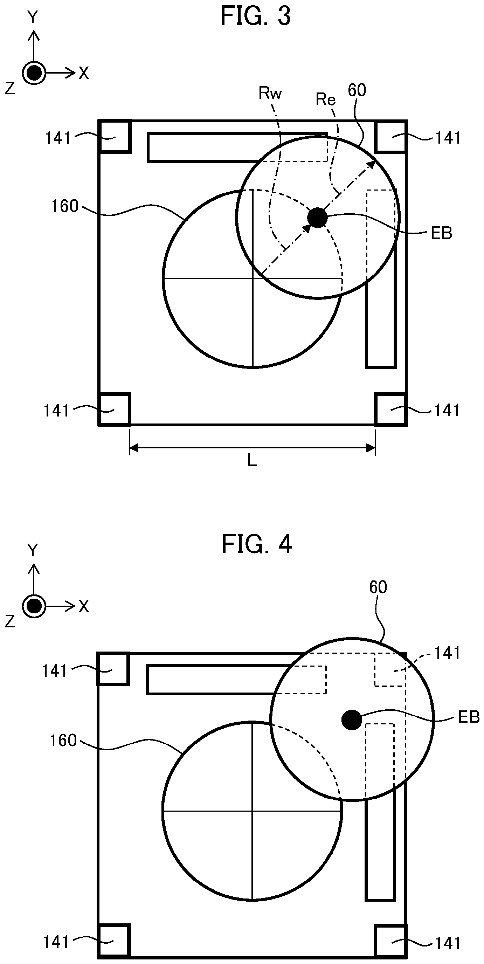

Fig. 3 is a diagram illustrating an arrangement relationship between the movable portion 100 and the electron optical system device 60.

As described above, the electron optical system device 60 is formed in a substantially cylindrical shape, and its radius is Re (second radius). Furthermore, the subject 160 is formed in a substantially disk shape, and its radius is Rw (first radius). In order not to distort the trajectory of the electron beam EB, when the subject 160 is irradiated with the electron beam EB, the magnet 141 is preferably located outside the electron optical system device 60 in plan view. In other words, an interval L between the magnets 141 preferably satisfies the relationship of the following Expression (1).

$$L \geq \sqrt{2} \times (Re + Rw) \ldots \quad \text{Expression (1)}$$

Therefore, in the design of the movable portion 100, it is preferable to determine the arrangement of the magnet 141 so as to satisfy the relationship of the above Expression (1). Furthermore, depending on the type of the electron optical system device 60, minute magnetization by the magnet 141 may become a problem. Therefore, when moving the movable portion 100, the controller 40 may control the movable portion 100 so as to always adopt a movement trajectory in which the magnet 141 does not overlap the range of the electron optical system device 60.

Fig. 4 is a diagram illustrating another arrangement relationship between the movable portion 100 and the electron optical system device 60.

In the illustrated state, the magnet 141 for attraction overlaps the electron optical system device 60 in plan view. In a situation where the electron beam EB is not emitted due to replacement of the subject 160 or the like, it is also assumed that the arrangement relationship as illustrated in the drawing is established. As illustrated in Fig. 1, the electron optical system device 60 is inserted into the insertion port 22a formed in the top plate 22. Therefore, in Fig. 4, the magnet 141 in the upper right corner is positioned in the range of the insertion port 22a, that is, in the range where the top plate 22 is not provided. As a result, the thrust force FA (see Fig. 1) is not generated between the magnet 141 at the upper right corner of Fig. 4 and the top plate 22.

Therefore, in such a case, the controller 40 preferably increases the current supplied to the coil 28 and generates a large thrust force FB (see Fig. 1) in the Z direction, thereby supporting the gravity FD of the movable portion 100. As described above, when the current flowing through the coil 28 is increased, minute vibration in the Z direction may occur in the movable portion 100. However, in a case where the subject 160 is not measured by the electron beam EB, even if minute vibration occurs in the movable portion 100, no particular problem occurs in many cases.

[Second Embodiment]

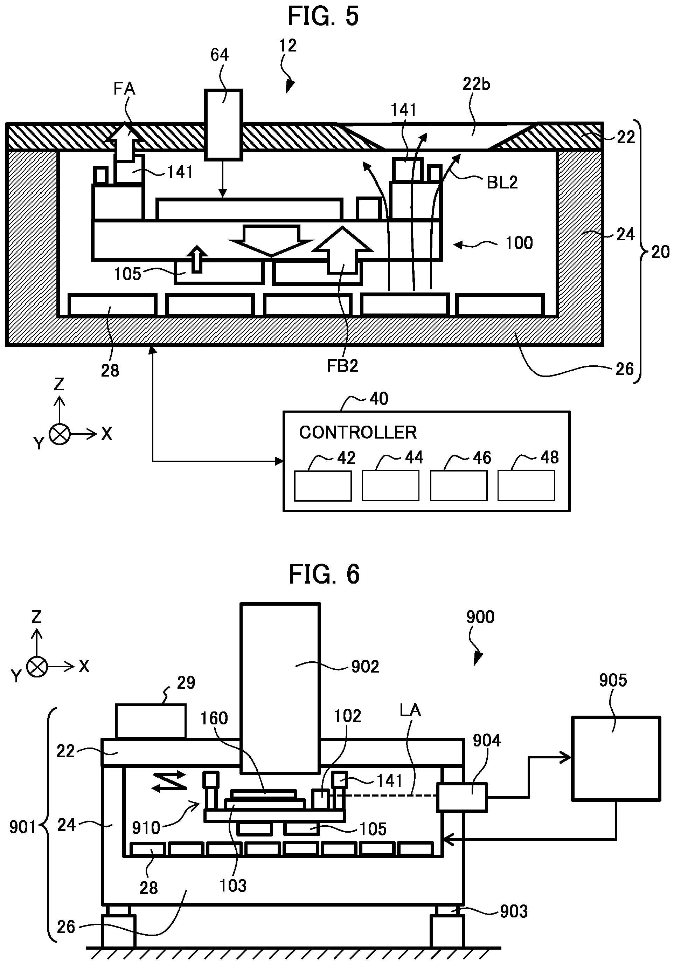

Fig. 5 is a schematic cross-sectional view of a magnetic levitation flat stage device 12 (stage device) according to a second embodiment. In the following description, portions corresponding to the respective portions of the first embodiment described above are denoted by the same reference numerals, and the description thereof may be omitted.

In Fig. 5, the magnetic levitation flat stage device 12 includes a fixing portion 20, a movable portion 100, and a controller 40 as in the first embodiment (see Fig. 1). Also in the present embodiment, the fixing portion 20 is formed in a substantially rectangular parallelepiped box shape, and includes a top plate 22, a side wall 24, and a bottom plate 26.

However, in the top plate 22 of the present embodiment, an insertion port 22b (through hole) tapered in an inverted conical shape is formed instead of the insertion port 22a illustrated in Fig. 1. In other words, by forming an acute edge on the inner periphery of the insertion port 22b, the decrease in suction force is made gentle. Also in the present embodiment, the electron optical system device 60 (see Fig. 1) is inserted into the insertion port 22b. In the top plate 22, an optical microscope 64 is attached at a position away from the insertion port 22b. The configuration of the present embodiment other than that described above is similar to that of the first embodiment (see Fig. 1).

In a case where the movable portion 100 is at the illustrated position, since the top plate 22 does not exist above the right magnet 141, the gravity on the right side of the movable portion 100 is not compensated by the magnet 141. Therefore, the controller 40 switches the control state so as to compensate a thrust force FB2 of the coil 28 in the Z direction also for the gravity. Thereafter, when the movable portion 100 moves and the magnet 141 enters directly below the magnetic material of the top plate 22 again, the controller 40 switches the control state so as not to add the gravity compensation to the Z-direction thrust force command value.

As described above, in the case of the position of Fig. 5, since the gravity of the movable portion 100 is supported by the thrust force generated by the coil 28, a leakage magnetic field BL2 from the coil 28 in the lower right portion of the movable portion 100 increases. As a result, the leakage magnetic field BL2 reaches above the movable portion 100. However, at the position of Fig. 5, since the electron optical system device 60 (see Fig. 1) does not irradiate the electron beam EB, this state is not particularly problematic in many cases.

However, even in a situation where the electron beam EB is not emitted, for example, in a case where the subject 160 is observed with the optical microscope 64, the vibration of the movable portion 100 may be suppressed to some extent. Therefore, in the present embodiment, as described above, an acute edge is formed on the inner periphery of the insertion port 22b. As a result, when the magnet 141 enters the region of the insertion port 22b, the decrease in the magnetic attractive force can be made gentle. As a result, it is possible to prevent the rapid fluctuation of the thrust force FB2 in the Z direction by the coil 28, and it is possible to suppress the vibration of the movable portion 100 even when the controller 40 switches the control of the thrust force in the Z direction.

[Third Embodiment]

Fig. 6 is a schematic cross-sectional view of a semiconductor measurement device 900 according to a third embodiment. In the following description, portions corresponding to the respective portions of the other embodiments described above are denoted by the same reference numerals, and the description thereof may be omitted.

The semiconductor measurement device 900 (stage device, vacuum device, and charged particle beam device) is a charged particle beam device in that the subject 160 is irradiated with an electron beam, that is, a charged particle beam, and is a vacuum device in that the periphery of the subject 160 is kept vacuum. The semiconductor measurement device 900 is, for example, a length measurement SEM as an application device of a scanning electron microscope (SEM).

In Fig. 6, the semiconductor measurement device 900 includes a vacuum chamber 901 (fixing portion), an electron optical system lens barrel 902 (charged particle beam radiation portion), a damping mount 903, a laser interferometer 904, a controller 905, and a stage device 910 (movable portion).

The vacuum chamber 901 includes a top plate 22, a side wall 24, a bottom plate 26, and a coil 28, similarly to the fixing portion 20 in the first and second embodiments. Furthermore, the vacuum chamber 901 includes a vacuum pump 29 that decompresses the internal space surrounded by the top plate 22, the side wall 24, and the bottom plate 26 to bring the internal space into a vacuum state. Here, the "vacuum state" refers to a state in which the pressure is at least lower than the atmospheric pressure.

The electron optical system lens barrel 902 is similar to the electron optical system device 60 in the first and second embodiments in that the subject 160 is irradiated with an electron beam. Furthermore, the electron optical system lens barrel 902 has a function of imaging a pattern on the surface of the subject 160, measuring a line width of the pattern, and evaluating shape accuracy. The subject 160 is, for example, a semiconductor wafer. The damping mount 903 supports the vacuum chamber 901 and attenuates vibration from the floor surface.

The stage device 910 is configured similarly to the movable portion 100 (see Figs. 1 to 5) in the first and second embodiments. The laser interferometer 904 measures the position of the bar mirror 102 attached to the stage device 910. The controller 905 is configured similarly to the controller 40 in the first and second embodiments. As a result, the controller 905 positions the subject 160 such as a semiconductor wafer held by the electrostatic chuck 103 of the stage device 910.

Since the semiconductor measurement device 900 of the present embodiment includes the stage device 910, it is possible to enhance the positioning accuracy of the subject 160 such as the semiconductor wafer and to suppress the leakage of the magnetic field. Therefore, the measurement accuracy of the semiconductor measurement device 900 as the charged particle beam device can be improved. In addition, since the levitation mechanism of the stage device 910 is a magnetic levitation type, the stage device can be easily applied to the semiconductor measurement device 900 that is a vacuum device, and can exhibit excellent effects such as reduction of contamination and suppression of heat generation.

[Comparative Examples]

<First Comparative Example>

Next, in order to clarify the effects of the above-described embodiments, various comparative examples will be described. In the following description, portions corresponding to the respective portions of the embodiments described above are denoted by the same reference numerals, and the description thereof may be omitted.

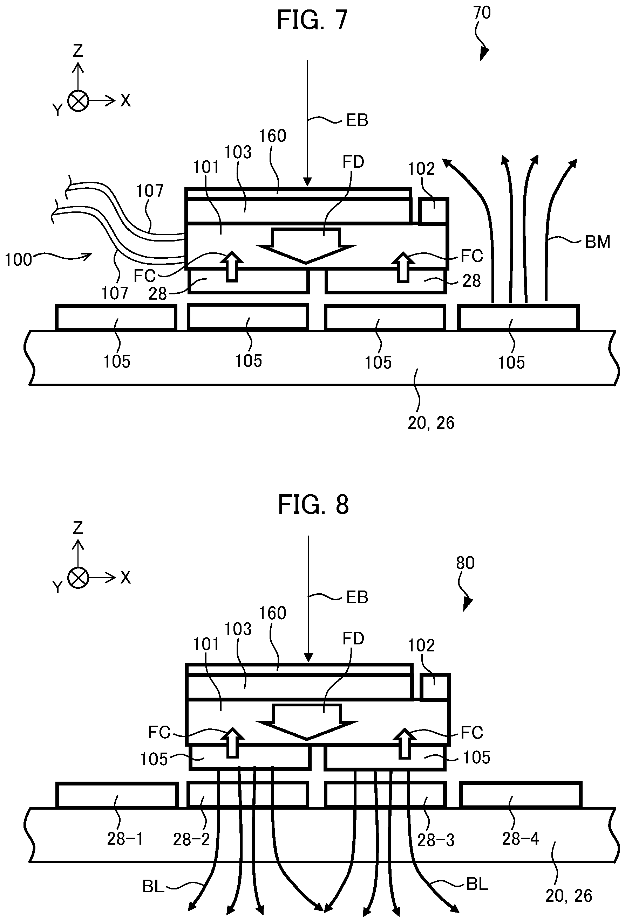

Fig. 7 is a schematic cross-sectional view of a magnetic levitation flat stage device 70 according to a first comparative example.

The magnetic levitation flat stage device 70 includes a fixing portion 20, a movable portion 100, and a controller 40 (see Fig. 1) as in the first embodiment (see Fig. 1). Also in the present comparative example, the fixing portion 20 is formed in a substantially rectangular parallelepiped box shape, and includes a top plate 22 (see Fig. 1), a side wall 24 (see Fig. 1), and a bottom plate 26. However, in Fig. 7, only a part of the bottom plate 26 is illustrated.

In the present comparative example, a plurality of magnets 105 are arranged on the upper surface of the bottom plate 26. The magnets 105 are formed in a rectangular plate shape and are two-dimensionally arranged along the X direction and the Y direction. On the other hand, a plurality of coils 28 are mounted on the lower surface of the top table 101. As described above, in the present comparative example, the arrangement of the coil 28 and the magnet 105 is opposite to that of the first embodiment. Also in the present comparative example, a thrust force FC due to the Lorentz force is generated with the magnet 105 by causing the current to flow through the coil 28. However, in the present comparative example, a component corresponding to the magnet 141 (see Fig. 1) in the first embodiment is not provided, and the thrust force FC and the gravity FD of the movable portion 100 are balanced.

Here, in a case where the mass of the movable portion 100 is large, or in a case where the device is in a vacuum environment and there is no heat transfer to air, it is necessary to prevent burning-out of the coil 28 due to heat generation of the coil 28 and thermal deformation due to a temperature rise of the top table 101. Therefore, in the present comparative example, a refrigerant pipe 107 is attached to the movable portion 100. The refrigerant is supplied to the coil 28 and the top table 101 through the refrigerant pipe 107 to cool them.

However, in the present comparative example, there arises a problem that the resistance by the refrigerant pipe 107 deteriorates the drive characteristics of the movable portion 100. In particular, in the magnetic levitation flat stage device 70 configured to exclude other frictional disturbance such as rolling guide (not illustrated), the influence of the resistance of the refrigerant pipe 107 is remarkably exhibited.

In addition, in the present comparative example, there is also a problem that the influence of a leakage magnetic field BM generated by the magnet 105 increases. In the configuration of Fig. 7, the magnet 105 is arranged along the entire movable range of the movable portion 100, and the magnetic circuit is not closed in the upward direction, so that the leakage magnetic field BM increases. The leakage magnetic field BM increases an adverse effect on the electron beam EB emitted from the electron optical system device 60 (see Fig. 1) or the like.

Furthermore, in the present comparative example, there is also a problem that the influence of noise generated by the current amplifier 48 increases. As described above, the magnitude of the noise generated by the current amplifier 48 increases as the maximum output current increases and as the output current increases. In the present comparative example, in order to balance the thrust force FC generated by the coil 28 and the gravity FD of the movable portion 100, it is necessary to flow a large current to the coil 28, and this also increases noise generated from the current amplifier 48. When the movable portion 100 minutely vibrates due to this noise, positioning resolution of the movable portion 100 is deteriorated, and positioning accuracy of the movable portion 100 is also deteriorated.

<Second Comparative Example>

Fig. 8 is a schematic cross-sectional view of a magnetic levitation flat stage device 80 according to a second comparative example.

The magnetic levitation flat stage device 80 includes a fixing portion 20, a movable portion 100, and a controller 40 (see Fig. 1) as in the first embodiment (see Fig. 1). Also in the present comparative example, the fixing portion 20 is formed in a substantially rectangular parallelepiped box shape, and includes a top plate 22 (see Fig. 1), a side wall 24 (see Fig. 1), and a bottom plate 26. However, in Fig. 8, only a part of the bottom plate 26 is illustrated. Furthermore, coils 28-1 to 28-4 in the drawing are similar to the coils 28 in the first embodiment, and these coils 28-1 to 28-4 may be collectively referred to as "coil 28".

In the present comparative example, the arrangement relationship of the coil 28 and the magnet 105 is similar to that of the first embodiment (see Fig. 1), and is opposite to the arrangement relationship of the first comparative example (see Fig. 7) described above. Fig. 8 illustrates a state in which the coils 28-2 and 28-3 and the two magnets 105 face each other on a one-to-one basis. Also in the present comparative example, the gravity FD of the movable portion 100 is supported by the thrust force FC generated by the coil 28. Here, since the coil 28 as a heating element is provided on the bottom plate 26, it is not necessary to connect the refrigerant pipe 107 (see Fig. 7) to the movable portion 100. Therefore, in the present comparative example, there is no problem that the refrigerant pipe 107 becomes a resistance of the movable portion 100.

In addition, since the magnetic circuit including the magnet 105 and the coils 28-2 and 28-3 mainly forms a magnetic field below the top table 101, the leakage magnetic field BL to the space above the top table 101 is reduced. However, also in the present comparative example, in order to support the gravity FD, it is necessary to flow a large current through the coils 28-2 and 28-3 facing the magnet 105, thereby enhancing the leakage magnetic field BL.

However, in the illustrated state, since the magnet 105 is located above the coils 28-2 and 28-3, the leakage magnetic field BL hardly reaches the path of the electron beam EB. As a result, the influence of the leakage magnetic field BL on the electron beam EB can be suppressed. However, since it is necessary to cause a large current to flow through the coils 28-2 and 28-3 in order to support the gravity FD of the movable portion 100 as described above, the problem of minute vibration due to the limitation of the dynamic range of the current amplifier 48 is not solved in the present comparative example.

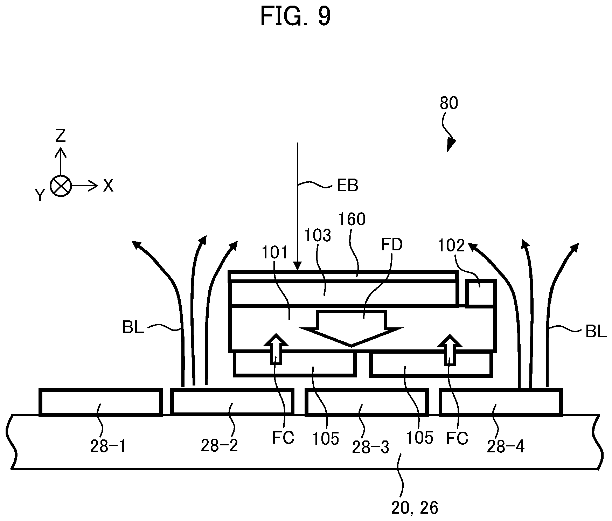

Fig. 9 is another schematic cross-sectional view of the magnetic levitation flat stage device 80 according to the second comparative example.

That is, the state illustrated in Fig. 9 is a state in which the movable portion 100 is moved in the X direction by 1/2 of the width of the coil 28 with respect to the state of Fig. 8. In this arrangement relationship, it is necessary to flow a large current to the coils 28-2, 28-3, and 28-4 in order to support the gravity FD of the movable portion 100. However, in the illustrated positional relationship, a part of the upper surfaces of the coils 28-2 and 28-4 is not covered with the magnet 105.

Therefore, the leakage magnetic field BL protruding from the portion of the magnet 105 reaches the vicinity of the electron beam EB above the subject 160, and causes distortion in the electron beam EB. As a result, for example, when the magnetic levitation flat stage device 80 is applied to an electron microscope, focus blurring or positional deviation occurs in an observation image. Also in the positional relationship of Fig. 9, it is necessary to increase the thrust force FC in the Z direction so that the thrust force FA of the movable portion 100 can be supported. Therefore, the problem of minute vibration due to the limitation of the dynamic range of the current amplifier 48 is not solved even in the positional relationship of Fig. 9.

[Effects of Embodiment]

As described above, according to the above-described embodiment, the stage device (10, 12, 900) includes: the fixing portion (20, 901) including the top plate 22 including the magnetic material, the bottom plate 26 facing the top plate 22, and the plurality of coils 28 provided on the upper surface of the bottom plate 26; the support portion (101) that supports the subject 160 to be positioned; and the movable portions 100 and 910 including the plurality of first magnets (141) that are mounted on the upper surface of the support portion (101), face the top plate 22, and generate the first thrust force (FA) with respect to the top plate 22, and the plurality of second magnets (105) that are provided on the lower surface of the support portion (101), face the coils 28, and generate the second thrust force (FB) with respect to the coils 28.

As a result, since the movable portions 100 and 910 can be supported by the first thrust force (FA) and the second thrust force (FB), the second thrust force (FB) can be reduced as compared with a case where there is no first thrust force (FA). As a result, the current flowing through the coil 28 can be reduced, so that the subject 160 can be appropriately positioned.

Further, when the subject 160 has a disk shape having a predetermined first radius (Rw) and the cylindrical electron optical system device 60 having the second radius (Re) faces the subject 160, it is more preferable that the plurality of first magnets (141) be separated at an interval of V2 times or more the sum of the first radius (Rw) and the second radius (Re). As a result, even when the peripheral edge of the subject 160 is measured by the electron optical system device 60, the electron optical system device 60 and the first magnet (141) can be sufficiently separated from each other.

Further, it is more preferable to provide the magnetic shield 125 on the lower surface of the support portion (101) and around the second magnet (105). As a result, the minute leakage magnetic field BL generated from the coil 28 can be shielded.

Further, the width LM of the magnetic shield 125 is more preferably 0.5 times or more the width of the coil 28. As a result, it is possible to more reliably shield the minute leakage magnetic field BL generated from the coil 28.

The stage device (10, 12, 900) further preferably includes the position sensor (143) that measures a distance between the movable portions 100 and 910 and the top plate 22. As a result, an appropriate current value to be supplied to the coil 28 can be determined on the basis of the measurement result of the position sensor (143).

Further, it is more preferable that the top plate 22 has the through hole (22b) whose peripheral surface is tapered. As a result, when the first magnet (141) moves to a position facing the through hole (22b), fluctuation of the first thrust force (FA) can be made gentle.

Further, it is more preferable to further include the controller 40 that controls the current supplied to the coil 28 so as to increase the second thrust force (FB) when the top plate 22 has the through hole (22a, 22b) and any one of the first magnets (141) faces the through hole (22a, 22b). Consequently, even when first magnet (141) faces through hole (22a, 22b), the posture of the movable portions 100 and 910 can be maintained in an appropriate range.

[Modifications]

The present invention is not limited to the above-described embodiments, and various modifications are possible. The above-described embodiments have been described for clear understating of the present invention, and are not necessarily limited to those having all the described configurations. In addition, some of the configurations of a certain embodiment may be replaced with the configurations of the other embodiments, and the configurations of the other embodiments may be added to the configurations of the embodiment. In addition, some of the configurations of each embodiment may be omitted, or added with other configurations or replaced with other configurations. Only control lines and information lines considered to be necessary for explanation are illustrated in the drawings, but not all the control lines and the information lines necessary for a product are illustrated. In practice, almost all the configurations may be considered to be connected to each other. Possible modifications to the above embodiment are, for example, as follows.

(1) In the third embodiment, the semiconductor measurement device 900 has been described as an example of the charged particle beam device and the vacuum device. However, the charged particle beam device and the vacuum device may be various devices other than the semiconductor measurement device 900. For example, as the charged particle beam device, the present invention can also be applied to a transmission electron microscope (TEM), an ion microscope, and the like. The charged particle beam device is also a vacuum device in many cases. As a vacuum device other than the charged particle beam device, for example, the present invention can also be applied to various fine processing devices.

Reference Signs List

10, 12 magnetic levitation flat stage device (stage device)
20 fixing portion
22 top plate
22a, 22b insertion port (through hole)
26 bottom plate
28 coil
29 vacuum pump
40 controller
60 electron optical system device
100, 910 movable portion
101 top table (support portion)
105 magnet (second magnet)

125 magnetic shield
141 magnet (first magnet)
143 displacement sensor (position sensor)
160 subject
900 semiconductor measurement device (stage device, vacuum device, and charged particle beam device)
901 vacuum chamber (fixing portion)
902 electron optical system lens barrel (charged particle beam radiation portion)
910 stage device (movable portion)
EB electron beam (charged particle beam)
FA thrust force (first thrust force)
FB thrust force (second thrust force)
LM width
Rw radius (first radius)
Re radius (second radius)

## Claims

1. A stage device comprising:

   a fixing portion including a top plate including a magnetic material, a bottom plate facing the top plate, and a plurality of coils provided on an upper surface of the bottom plate; and
   a movable portion including a support portion that supports a subject to be positioned, a plurality of first magnets that are mounted on an upper surface of the support portion, face the top plate, and generate a first thrust force against the top plate, and a plurality of second magnets that are provided on a lower surface of the support portion, face the coil, and generate a second thrust force against the coil.

2. The stage device according to claim 1, wherein

   the subject has a disk shape having a predetermined first radius, and a cylindrical electron optical system device having a second radius faces the subject, and
   a plurality of the first magnets are separated at an interval of $\sqrt{2}$ times or more with respect to a sum of the first radius and the second radius.

3. The stage device according to claim 2, wherein
   a magnetic shield is provided on a lower surface of the support portion and around the second magnet.

4. The stage device according to claim 3, wherein
   a width of the magnetic shield is 0.5 times or more a width of the coil.

5. The stage device according to claim 1, further comprising:
   a position sensor that measures a distance between the movable portion and the top plate.

6. The stage device according to claim 1, wherein
   the top plate has a through hole whose peripheral surface is tapered.

7. The stage device according to claim 1, wherein

   the top plate has a through hole, and
   the stage device further comprises a controller that controls a current supplied to the coil so as to increase the second thrust force when any of the first magnets faces the through hole.

8. A charged particle beam device comprising:

   a fixing portion including a top plate including a magnetic material, a bottom plate facing the top plate, and a plurality of coils provided on an upper surface of the bottom plate;
   a movable portion including a support portion that supports a subject to be positioned, a plurality of first magnets that are mounted on an upper surface of the support portion, face the top plate, and generate a first thrust force against the top plate, and a plurality of second magnets that are provided on a lower surface of the support portion, face the coil, and generate a second thrust force against the coil; and

a charged particle beam radiation portion that irradiates a charged particle beam to the subject.

9. A vacuum device comprising:

a fixing portion including a top plate including a magnetic material, a bottom plate facing the top plate, and a plurality of coils provided on an upper surface of the bottom plate;

a movable portion including a support portion that supports a subject to be positioned, a plurality of first magnets that are mounted on an upper surface of the support portion, face the top plate, and generate a first thrust force against the top plate, and a plurality of second magnets that are provided on a lower surface of the support portion, face the coil, and generate a second thrust force against the coil; and

a vacuum pump that lowers an air pressure of an internal space of the fixing portion than an atmospheric pressure.

# FIG. 1

# FIG. 2

# FIG. 3

# FIG. 4

## FIG. 5

## FIG. 6

# FIG. 7

# FIG. 8

FIG. 9

## INTERNATIONAL SEARCH REPORT

| International application No. |
|---|
| **PCT/JP2022/030744** |

**A. CLASSIFICATION OF SUBJECT MATTER**

*H01L 21/68*(2006.01)i; *H01J 37/18*(2006.01)i; *H01J 37/20*(2006.01)i
FI: H01L21/68 K; H01J37/18; H01J37/20 A

According to International Patent Classification (IPC) or to both national classification and IPC

**B. FIELDS SEARCHED**

Minimum documentation searched (classification system followed by classification symbols)

H01L21/68; H01J37/18; H01J37/20

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2001-057325 A (NIKON CORP) 27 February 2001 (2001-02-27) paragraphs [0040]-[0078], [0115], [0116], fig. 1-7 | 1, 6, 7 |
| Y | | 2-5, 8, 9 |
| Y | JP 2000-138279 A (NIKON CORP) 16 May 2000 (2000-05-16) paragraphs [0039]-[0078], fig. 1-4 | 2-5 |
| Y | JP 2003-037047 A (CANON INC) 07 February 2003 (2003-02-07) paragraphs [0001]-[0006], [0026], [0027] | 3, 4 |
| Y | JP 2019-204673 A (HITACHI LTD) 28 November 2019 (2019-11-28) paragraphs [0014]-[0042], [0065]-[0069], fig. 12 | 8, 9 |

☐ Further documents are listed in the continuation of Box C.  ☑ See patent family annex.

| | |
|---|---|
| \* Special categories of cited documents: <br> "A" document defining the general state of the art which is not considered to be of particular relevance <br> "E" earlier application or patent but published on or after the international filing date <br> "L" document which may throw doubts on priority claim(s) or which is cited to establish the publication date of another citation or other special reason (as specified) <br> "O" document referring to an oral disclosure, use, exhibition or other means <br> "P" document published prior to the international filing date but later than the priority date claimed | "T" later document published after the international filing date or priority date and not in conflict with the application but cited to understand the principle or theory underlying the invention <br> "X" document of particular relevance; the claimed invention cannot be considered novel or cannot be considered to involve an inventive step when the document is taken alone <br> "Y" document of particular relevance; the claimed invention cannot be considered to involve an inventive step when the document is combined with one or more other such documents, such combination being obvious to a person skilled in the art <br> "&" document member of the same patent family |

| Date of the actual completion of the international search | Date of mailing of the international search report |
|---|---|
| **05 September 2022** | **13 September 2022** |

| Name and mailing address of the ISA/JP | Authorized officer |
|---|---|
| **Japan Patent Office (ISA/JP)** <br> **3-4-3 Kasumigaseki, Chiyoda-ku, Tokyo 100-8915** <br> **Japan** | |
| | Telephone No. |

Form PCT/ISA/210 (second sheet) (January 2015)

INTERNATIONAL SEARCH REPORT
Information on patent family members

International application No.

**PCT/JP2022/030744**

| Patent document cited in search report | | | Publication date (day/month/year) | Patent family member(s) | Publication date (day/month/year) |
|---|---|---|---|---|---|
| JP | 2001-057325 | A | 27 February 2001 | (Family: none) | |
| JP | 2000-138279 | A | 16 May 2000 | (Family: none) | |
| JP | 2003-037047 | A | 07 February 2003 | (Family: none) | |
| JP | 2019-204673 | A | 28 November 2019 | US 2021/0027978 A1 paragraphs [0026]-[0054], [0077]-[0081], fig. 12 WO 2019/225110 A1 | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2008527964 T